# EUROPEAN PATENT APPLICATION

(11) **EP 3 502 765 A1**
(43) Date of publication of application: **26.06.2019**
(21) Application number: 17841358.9
(22) Date of filing: 31.07.2017
(51) Int. Cl.: G02B 27/02, B81B 7/02, G09G 3/02, G09G 3/20, H02N 2/12, H04N 5/64, G02B 26/08, G02B 26/10, G02B 5/32, G09G 3/00, G02B 27/01, G03H 1/26, G03H 1/02, G03H 1/30, G03H 1/04

(54) **IMAGE DISPLAY DEVICE**

(30) Priority: 16.08.2016 JP 2016159531
(71) Applicant: Konica Minolta, Inc., Tokyo 100-7015 (JP)
(72) Inventor: INAGAKI, Yoshihiro, Tokyo 100-7015 (JP)
(74) Representative: MFG Patentanwälte Meyer-Wildhagen Meggle-Freund Gerhard PartG mbB
(86) International application number: PCT/JP2017/027605
(87) International publication number: WO 2018/034131

(57) **Abstract**

Provided is a low-cost, compact image display device capable of displaying a suitable image using holograms. This image display device includes: a display section in which a single-exposure hologram and a multiple-exposure hologram are arranged side by side; a plurality of optical units that emits light toward the single-exposure hologram and the multiple-exposure hologram; and a control section that at least partially controls the amount of light emitted from the optical units. The control section controls the amount of light emitted from the optical units such that the intensity of diffracted light emitted from the single-exposure hologram to enter the eye of the observer and the intensity of diffracted light emitted from the multiple-exposure hologram to enter the eye of the observer approach one another, with a boundary interposed between the single-exposure hologram and the multiple-exposure hologram.

## Description

### Technical Field

The present invention relates to an image display device.

### Background Art

An image display device that enables what is called through display is used, for example, in a head mount display (HMD) or the like which is a wearable terminal. Through display enables the observer to view a displayed image and observe the outside world. In recent years, various types of image display devices that guide image light from display elements to the observer's pupil using holograms have been proposed.

For example, Patent Literature 1 discloses an eyeglass-type image display device that scans laser light and diffracts it toward the eyes using a volume hologram to form an image, which can be observed by the observer. In this conventional example, one scanning device corresponding to one eye is provided, and one hologram corresponding thereto is formed on the portion corresponding to a lens. When observing a display image with both eyes, two sets of scanning devices and holograms are required.

### Citation List

### Patent Literature

Patent Literature 1: JP H10-301055 A
Patent Literature 2: JP H06-342128 A

### Summary of Invention

### Technical Problem

In the case of displaying an image with a wider angle of view by using a single scanning device in the eyeglass-type image display device worn by the observer, part of image light directed to the hologram is blocked by the face of the observer. Therefore, there is a limit to the expansion of the angle of view. In order to prevent image light from being blocked, it is conceivable to arrange the hologram at a distance in front of the observer, which increases the size of the image display device and causes degradation in usability.

In order to solve such a problem, an attempt has been made to form one image as a whole by irradiating divided regions with light from a plurality of scanning devices. However, when displaying an image with a wide angle of view using such a configuration, light from one scanning device and light from another scanning device overlap in some region. When observing an image with both eyes, the hologram that sends diffracted light to the right eye and the hologram that sends diffracted light to the left eye may spatially overlap between the left and right eyes.

Here, in the case of producing a general hologram, by irradiating a material with laser light (object light) and reference light at a predetermined angle, light interference is caused inside the material (single exposure), whereby grating fringes having differences in refractive index and arranged in one direction are formed. The hologram formed in this way is referred to as a single-exposure hologram here. However, in the case of a single-exposure hologram, in order to generate diffraction in a predetermined direction and make it enter the eyes of the observer, the incident angle to the hologram is limited, causing the following problem: even if a single-exposure hologram is adopted at a position where light beams from two scanning devices enter, light from only one scanning device can be diffracted.

To address this problem, Patent Literature 2 discloses a technique of irradiating a material with a plurality of laser light beams (object light) and a plurality of reference light beams shifted to cause light interference inside the material (multiple exposure), thereby forming grating fringes having differences in refractive index and arranged in a plurality of directions. The hologram formed in this way is referred to as a multiple-exposure hologram. The multiple-exposure hologram can diffract light that has entered in a plurality of directions. Therefore, the multiple-exposure hologram can be installed at a position where light beams from a plurality of scanning devices enter, and can generate a plurality of diffracted light beams directed toward the eyes of the observer. However, it has been found that a suitable image cannot be formed just by installing a multiple-exposure hologram at a position where light beams from a plurality of scanning devices enter.

The present invention has been made in view of the problems of the conventional techniques, and an object thereof is to provide a compact image display device capable of displaying a suitable image using holograms

### Solution to Problem

In order to realize at least one of the above objects, an image display device reflecting one aspect of the present invention includes:
a display section in which a single-exposure hologram and a multiple-exposure hologram are arranged side by side;
a plurality of optical units that emits light toward the single-exposure hologram and the multiple-exposure hologram; and
a control section that at least partially controls an amount of light emitted from the optical units, wherein
when light emitted from any of the optical units enters the single-exposure hologram along a predetermined incident direction, the light is diffracted in a direction toward an eye of an observer,
when light emitted from one of the optical units enters the multiple-exposure hologram along a first incident direction, the light is diffracted in a direction toward the eye of the observer, and when light emitted from another optical unit enters the multiple-exposure hologram along a second incident direction different from the first incident direction, the light is diffracted in a direction toward the eye of the observer, and
the control section controls the amount of light emitted from the optical units such that an intensity of diffracted light emitted from the single-exposure hologram to enter the eye of the observer and an intensity of diffracted light emitted from the multiple-exposure hologram to enter the eye of the observer approach one another, with a boundary interposed between the single-exposure hologram and the multiple-exposure hologram.

### Advantageous Effects of Invention

According to the present invention, it is possible to provide a low-cost, compact image display device capable of displaying a suitable image using holograms.

### Brief Description of Drawings

Fig. 1 is a schematic diagram illustrating cross-sectional structures of holograms.
Fig. 2 is a perspective view around the left eye of the observer wearing an image display device of the present embodiment.
Fig. 3 is a perspective view around the right eye of the observer wearing the image display device of the present embodiment.
Fig. 4 is a schematic diagram illustrating a part of the image display device of the present embodiment.
Fig. 5 is a front view of a scanning mirror 14.
Fig. 6 is a cross-sectional view illustrating a unimorph structure of the scanning mirror 14.
Fig. 7 is a geometric diagram illustrating the positional relationship between the left eye EYL of the observer, a resin plate PL, an emission point P1 of a first optical device, and an emission point P2 of a second optical device.
Fig. 8 is a diagram illustrating time-division control of a semiconductor laser performed by a control section CONT.
Fig. 9 is a geometric diagram illustrating the positional relationship between the observer's eyes EYL and EYR, the resin plate PL, the emission point P1 of the first optical device, and an emission point P4 of a fourth optical device.
Fig. 10 is a diagram illustrating oscillation states of a reflecting section of the scanning mirror.
Fig. 11 is a diagram illustrating laser light emitted from the first optical device 10 as seen from the scanning mirror side.
Fig. 12 is a diagram illustrating laser light emitted from the second optical device 20 as seen from the scanning mirror side.

### Description of Embodiments

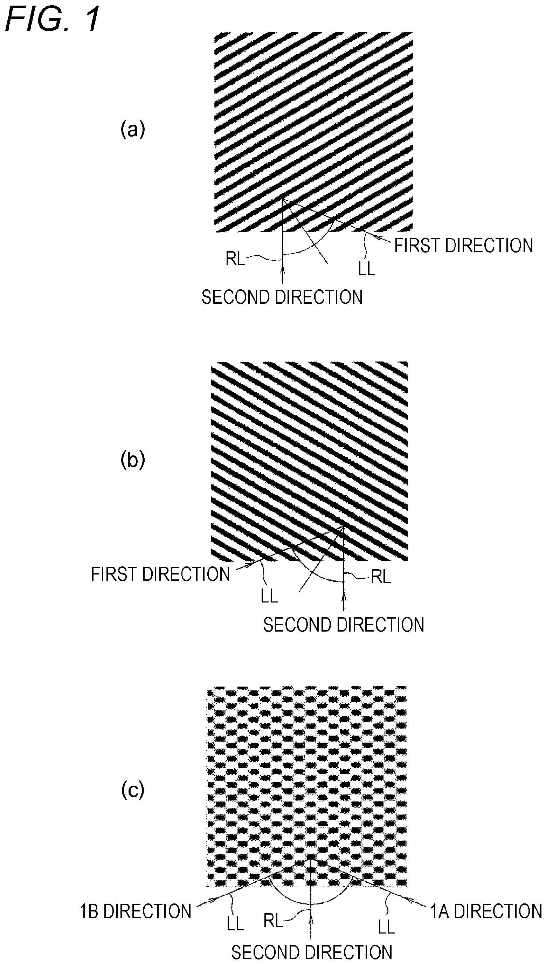

Hereinafter, an embodiment of the present invention will be described with reference to the drawings. First, a single-exposure hologram and a multiple-exposure hologram will be described. Fig. 1 is a schematic diagram illustrating cross-sectional structures of holograms, in which a white region is a high refractive region and a black region is a low refractive region. First, in the case of producing a single-exposure hologram illustrated in Figs. 1(a) and 1(b), for example, an organic photorefractive material is irradiated with laser light LL along the first direction and irradiated with reference light RL in the second direction. Then, interference fringes are generated in the direction orthogonal to the bisector of the first and second directions, and high refractive regions and low refractive regions are generated along the interference fringes.

When laser light enters the single-exposure hologram produced in this way along the first direction, diffracted light is generated along the second direction. Therefore, by appropriately setting the first direction and the second direction for production, it is possible to obtain a hologram that generates diffracted light in the direction toward the eyes of the observer, for example. However, such characteristics of the single-exposure hologram have angle selectivity corresponding to the first direction besides wavelength selectivity corresponding to the wavelength of the laser light used for production, which is inconvenient for use.

In order to solve the problem of this single hologram, multiple-exposure holograms were developed. In the case of producing a multiple-exposure hologram illustrated in Fig. 1(c), for example, an organic photorefractive material is irradiated with laser light LL from two directions along the 1A direction and the 1B direction and irradiated with reference light RL along the second direction. Then, interference fringes are generated in the two directions, and high refractive regions and low refractive regions having a checkered pattern are generated as illustrated in the figure. That is, the multiple-exposure hologram has high refractive regions and low refractive regions distributed as if the single-exposure holograms illustrated in Figs. 1(a) and 1(b) were superimposed.

When laser light enters the multiple-exposure hologram produced in this way along the 1A direction, diffracted light is generated along the second direction. When laser light enters the multiple-exposure hologram along the 1B direction, diffracted light is generated along the second direction. Therefore, it is possible to obtain a hologram capable of emitting diffracted light in the same direction even when laser light enters from two different directions. In the above example, the second direction in which reference light RL enters is one direction. However, reference light RL may enter in different directions. In that case, diffracted light is emitted in different directions.

However, in the case of producing a multiple-exposure hologram, if the local refractive index of the produced volume hologram is not in proportion to the local intensity of laser light used for production, the diffraction efficiency differs from that without multiple exposure. In the single-exposure holograms illustrated in Figs. 1(a) and 1(b), high refractive regions and low refractive regions are separated, and the refractive index modulation close to the maximum value determined by the difference between the two refractive indices is obtained. Refractive index modulation is related to diffraction efficiency: the larger refractive index modulation, the higher diffraction efficiency. Therefore, if multiple exposure is not performed, it is preferable that high refractive regions and low refractive regions be separated in this way. However, since it is impossible to make a difference greater than the difference in refractive index between the two regions, two fringes are distributed competitively at the multiple-exposure position, and the refractive index modulation is smaller than when multiple exposure is not performed. That is, multiple-exposure holograms are generally less efficient than single-exposure holograms. Therefore, in the image display device of the present embodiment, single-exposure holograms and multiple-exposure holograms are arranged as hologram sheets at appropriate positions such that the advantages of both holograms can be utilized to the utmost.

More specifically, a single-exposure hologram is arranged at a position where laser light enters from only one laser light source, and a multiple-exposure hologram is arranged at a position where laser light enters from two laser light sources along different directions. Consequently, diffracted light emitted from any of the holograms enters the eyes of the observer, so that an image with a wide angle of view is formed while facilitating downsizing of the image display device.

When forming one image across a single-exposure hologram and a multiple-exposure hologram, if laser light beams of the same amount of light are radiated, the phenomenon that the intensity of diffracted light emitted from the multiple-exposure hologram is smaller than the intensity of diffracted light emitted from the single-exposure hologram occurs due to the difference in efficiency between the holograms. Therefore, when a plurality of diffracted light beams emitted from the multiple-exposure hologram is directed in different directions, it is desirable that the amount of laser light to be radiated to the single-exposure hologram be smaller than the amount of laser light to be radiated to the multiple-exposure hologram by the value corresponding to the difference in efficiency, with the boundary interposed therebetween. On the other hand, when a plurality of diffracted light beams emitted from the multiple-exposure hologram is directed in the same direction, it is desirable that the amount of laser light to be radiated to the multiple-exposure hologram be smaller than the amount of laser light to be radiated to the single-exposure hologram by the value corresponding to the sum of diffracted light beams, with the boundary interposed therebetween. As a result, the intensity of diffracted light emitted from the single-exposure hologram toward the eyes of the observer can be made substantially equal to the intensity of diffracted light emitted from the multiple-exposure hologram toward the eyes of the observer, with the boundary interposed between the single-exposure hologram and the multiple-exposure hologram. Therefore, even in the case of forming one image across the single-exposure hologram and the multiple-exposure hologram, the observer who observes the image may not feel discomfort.

Note that the intensities of diffracted light beams emitted from the single-exposure hologram and the multiple-exposure hologram need not be equal completely, with the boundary interposed therebetween. The intensities only need to approach one another to an extent that does not cause discomfort for the observer. When comparing the intensity of diffracted light emitted from the single-exposure hologram closest to the boundary between the single-exposure hologram and the multiple-exposure hologram and the intensity of diffracted light emitted from the multiple-exposure hologram closest to this boundary, for example, it is preferable to make a comparison in terms of the average intensity per unit area (for example, 1 mm²), not on a pixel basis.

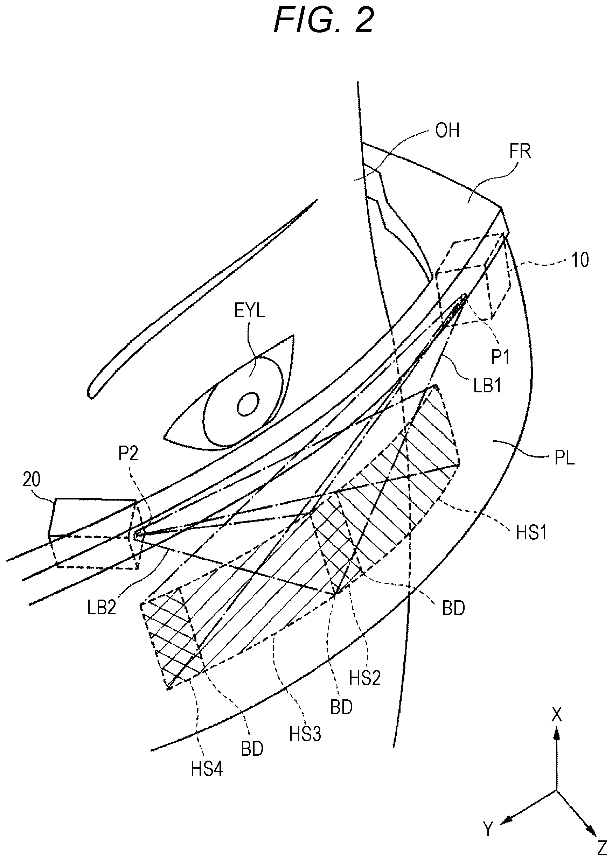

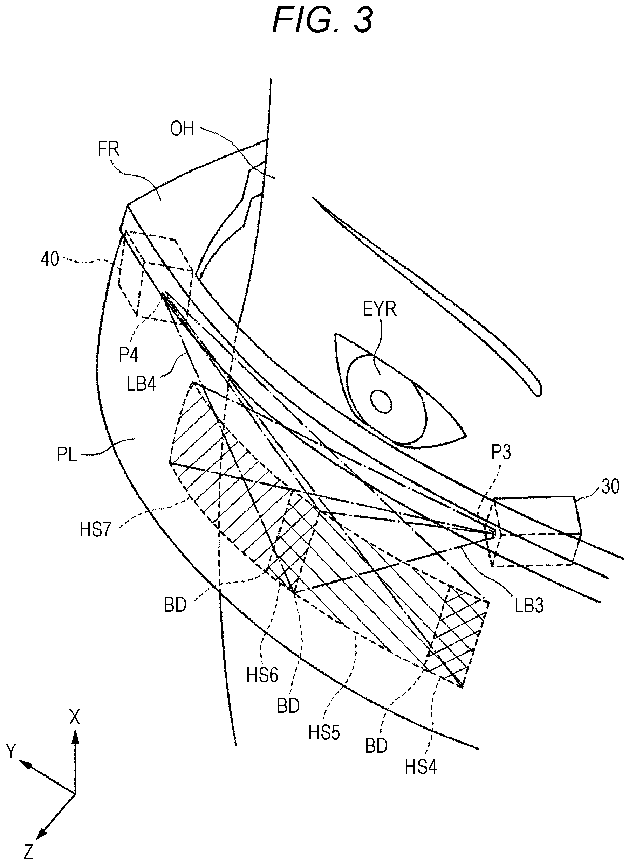

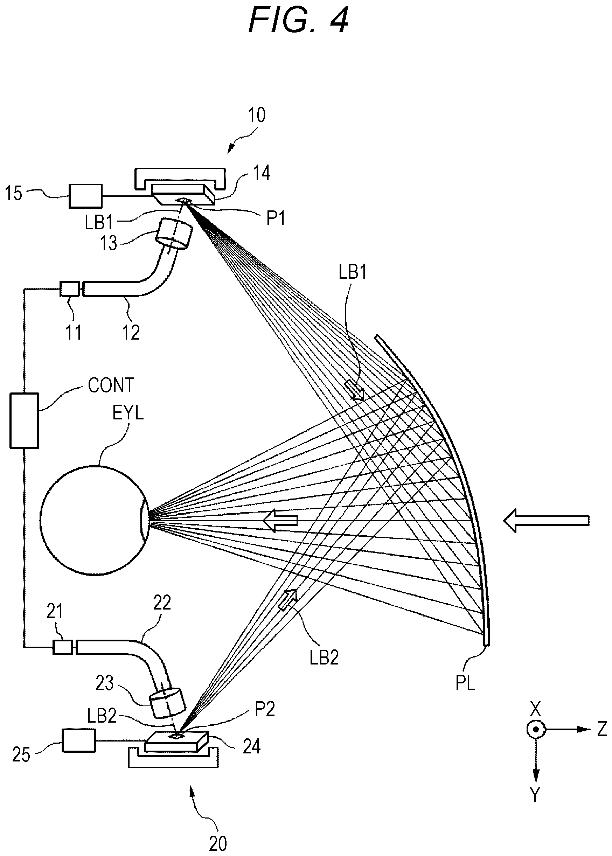

Fig. 2 is a perspective view around the left eye of the observer wearing the image display device of the present embodiment, and Fig. 3 is a perspective view around the right eye of the observer wearing the image display device of the present embodiment. Fig. 4 is a schematic diagram illustrating a part of the image display device of the present embodiment. In the figures, the direction from the observer to the front is the Z direction, the horizontal direction with respect to the observer is the Y direction, and the vertical direction with respect to the observer is the X direction. Hereinafter, an optical device is also referred to as an optical unit.

In Figs. 2 and 3, a U-shaped frame FR is worn on the observer's head OH, and a continuous curved resin plate PL is attached to the lower side of the frame FR. Hologram sheets (display section) are arranged as described later on a part of the transparent resin plate PL. As illustrated in Fig. 2, on the frame FR, a first optical device 10 and a second optical device 20 are fixed at positions higher than the center of the left eye EYL. Further, in Fig. 2, rectangular hologram sheets HS1, HS2, HS3, and HS4 are formed adjacent to each other on the resin plate PL with no gaps in order from the side close to the first optical device 10. Let the boundary between them be BD. Here, the hologram sheets HS1 and HS3 indicated by single hatching are single-exposure holograms, and the hologram sheets HS2 and HS4 indicated by double hatching are multiple-exposure holograms. Note that hologram sheets are formed by exposing one continuous photosensitive material to light while shifting the position of exposure.

On the other hand, as illustrated in Fig. 3, on the frame FR, a third optical device 30 and a fourth optical device 40 are fixed at positions higher than the center of the right eye EYR. Further, in Fig. 3, rectangular hologram sheets HS7, HS6, HS5, and HS4 are formed adjacent to each other on the resin plate PL with no gaps in order from the side close to the fourth optical device 40. Let the boundary between them be BD. Here, the hologram sheets HS7 and HS5 indicated by single hatching are single-exposure holograms, the hologram sheet HS2 indicated by double hatching is a multiple-exposure hologram, and the hologram sheet HS4 is commonly illustrated in Figs. 2 and 3. As is evident from Figs. 2 and 3, the image display device according to the present embodiment takes the form of a head mount display (HMD) so that the observer can observe images formed by the hologram sheets and observe the scenery of the outside world through the resin plate PL at the same time.

In Fig. 4, the first optical device 10 includes a semiconductor laser (laser light source) 11, a light guide path 12 that transmits the light flux emitted from the semiconductor laser 11, a lens 13 that focuses laser light LB1 emitted from the light guide path 12, a scanning mirror 14 that reflects and two-dimensionally scans the laser light LB1 focused by the lens 13, and a power supply section 15 that supplies high-frequency power for driving the scanning mirror 14. Note that a control section CONT for controlling the first semiconductor laser 11 is separately provided. The inclination angle (reflection angle) of the scanning mirror 14 can be changed, and two-dimensional scanning of the laser light LB1 is performed by changing the inclination angle of the scanning mirror 14.

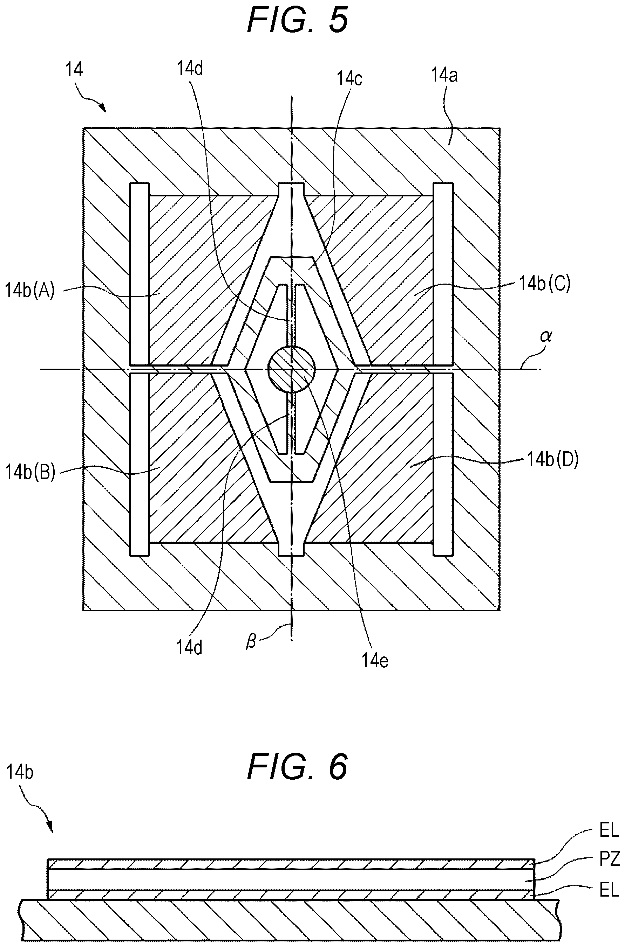

Fig. 5 is a front view of the scanning mirror 14. In the present embodiment, the scanning mirror 14 that constitutes the scanning system is incorporated in a micro electro mechanical system (MEMS) to have a substantially flat shape with a small thickness and a small size. As a specific structure, as illustrated in Fig. 5, the scanning mirror 14 includes a structure obtained by subjecting a silicon substrate to an etching process or the like. The scanning mirror 14 integrally has a fixed frame 14a, a driving section 14b, a movable frame 14c, and the like. In the following description, the axis traversing the center of the scanning mirror 14 in the horizontal direction in Fig. 5 is defined as the α axis, and the axis traversing the center of the scanning mirror 14 in the vertical direction in Fig. 5 is defined as the β axis.

The fixed frame 14a is a portion corresponding to the outer edge of the scanning mirror 14 and surrounds the other portions (driving section 14b, movable frame 14c, and the like). The driving section 14b is separated from the fixed frame 14a in the α axis direction and is connected to the fixed frame 14a in the β axis direction. Further, the driving section 14b includes four unimorph structures, and the four unimorph structures are arranged so as to be symmetrical with respect to the α-axis and the β-axis as symmetry axes and to be separated from each other. As illustrated in Fig. 6, a unimorph structure as the driving section 14b includes a piezoelectric element PZ (obtained by subjecting a sintered body made of PZT or the like to a polarization process) sandwiched between a pair of electrodes EL. The piezoelectric element PZ with the pair of electrodes EL is bonded to the region of a silicon substrate to be the driving section 14b.

In such a driving section 14b, when a voltage is applied to the pair of electrodes EL, the piezoelectric element PZ sandwiched between the pair of electrodes EL extends or contracts. When the piezoelectric element PZ extends or contracts, the region of the silicon substrate to be the driving section 14b extends or contracts accordingly. In other words, the driving section 14b is driven in response to power being supplied from the power supply section 15.

As illustrated in Fig. 5, the movable frame 14c is a substantially rhomboid shaped frame located inside the driving section 14b. Both ends of the movable frame 14c on the α axis are connected to the driving section 14b, and the other portions are separated from the driving section 14b. As a result, the movable frame 14c is rotatable around the α axis.

A pair of torsion bars 14d extending along the β axis direction are provided inside the movable frame 14c. The pair of torsion bars 14d are arranged so as to overlap with the β axis and symmetrical with respect to the α axis. Further, one end of each of the pair of torsion bars 14d is connected to the end of the movable frame 14c on the β axis.

The reflecting section 14e is arranged between the opposite other ends of the pair of torsion bars 14d, and is supported by the other ends. Therefore, the scanning mirror 14 is rotated around the α axis together with the movable frame 14c, and is rotated around the β axis with the torsion bars 14d as the rotation axis. Note that the reflecting section 14e is formed in a substantially circular shape, and is obtained by bonding a reflecting film made of gold, aluminum, or the like onto a silicon substrate.

The scanning operation of the first mirror 14 is performed by adjusting the timing of driving (extending and contracting) the four driving sections 14b and oscillating the scanning mirror 14 around the α axis and the β axis. For example, the frequency of oscillation around the α axis is set to about 60 Hz, and the frequency of oscillation around the β axis is set to about 30 kHz.

The four driving sections 14b are denoted by reference signs 14b(A) to 14b(D) for concrete description. When oscillating the scanning mirror 14 around the α axis, the driving sections 14b(A) and 14b(C) are treated as one set, the driving sections 14b(B) and 14b(D) are treated as the other set, and voltages of different polarities are applied to the one set and the other set. In this case, when the driving sections 14b(A) and 14b(C) as the one set are deformed in the extending direction, the driving sections 14b(B) and 14b(D) as the other set are deformed in the contracting direction. When the driving sections 14b(A) and 14b(C) as the one set are deformed in the contracting direction, the driving sections 14b(B) and 14b(D) as the other set are deformed in the extending direction. As a result, the reflecting section 14e oscillates around the α axis together with the movable frame 14c, and the inclination of the reflecting section 14e changes around the α axis. Note that the torsion direction of the torsion bar 14d is the direction orthogonal to the oscillation direction around the α axis, and thus does not affect the oscillation of the reflecting section 14e around the α axis.

When oscillating the scanning mirror 14 around the β axis, the driving sections 14b(A) and 14b(B) are treated as one set, the driving sections 14b(C) and 14b(D) are treated as the other set, and voltages of different polarities are applied to the one set and the other set. In this case, when the driving sections 14b(A) and 14b(B) as the one set are deformed in the extending direction, the driving sections 14b(C) and 14b(D) as the other set are deformed in the contracting direction. When the driving sections 14b(A) and 14b(B) as the one set are deformed in the contracting direction, the driving sections 14b(C) and 14b(D) as the other set are deformed in the extending direction. As a result, the reflecting section 14e oscillates around the β axis together with the movable frame 14c, and the inclination of the reflecting section 14e changes around the β axis.

At this time, if the reflecting section 14e is inclined around the β axis only by deforming the driving section 14b, the change in the inclination of the reflecting section 14e around the β axis is small. Therefore, when the scanning operation is actually performed, the frequency of the voltage applied to the driving section 14b is set such that the reflecting section 14e resonates according to the frequency of the voltage applied to the driving section 14b. That is, the oscillation of the reflecting section 14e around the β axis is made with reference to the torsion bar 14d.

By operating the scanning mirror 14 as described above, it is possible to rotate the reflecting section 14e around the two orthogonal axes, and to perform two-dimensional scanning of the first laser light LB1 that has entered the reflecting section 14e. In addition, desired images can be formed by performing on/off control on the semiconductor laser by the control section CONT.

Furthermore, in Fig. 4, the second optical device 20 includes a semiconductor laser (laser light source) 21, a light guide path 22 that transmits the light flux emitted from the semiconductor laser 21, a lens 23 that focuses laser light LB2 emitted from the light guide path 22, a second scanning mirror 24 that reflects and two-dimensionally scans the laser light LB2 focused by the lens 23, and a power supply section 25 that supplies high-frequency power for driving the second scanning mirror 24. Note that the control section CONT also controls the semiconductor laser 21 as well as the semiconductor laser 11. Further, since the second scanning mirror 24 has the same configuration as the first scanning mirror, the explanation of the operation of the second scanning mirror 24 is omitted. Furthermore, since the third optical device 30 and the fourth optical device 40 have the same configuration, the explanation thereof is omitted. Note that the control section CONT is also configured to individually control the semiconductor lasers of the third optical device 30 and the fourth optical device 40.

As described above, the hologram sheets HS1 to HS7 are formed side by side on the resin plate PL. Here, the deflection width of the reflecting section of the scanning mirror used in the present embodiment is limited, and there is a limit to the angle (deflection angle) of deflecting the reflected light. Therefore, it is difficult to form an image with a large angle of view using a single optical device. Thus, four optical devices are used. In particular, in order to allow the observer to observe an image with a wider angle of view at a small deflection angle, laser light emitted from the first optical device 10 and the fourth optical device 40 arranged outside enters the hologram sheets HS3 to HS5 positioned in the middle of the hologram sheet row, whereas laser light emitted from the second optical device 20 and the third optical device 30 arranged inside enters the hologram sheets HS1 and HS2 and the hologram sheets HS6 and HS7, respectively, positioned at the ends of the hologram sheet row.

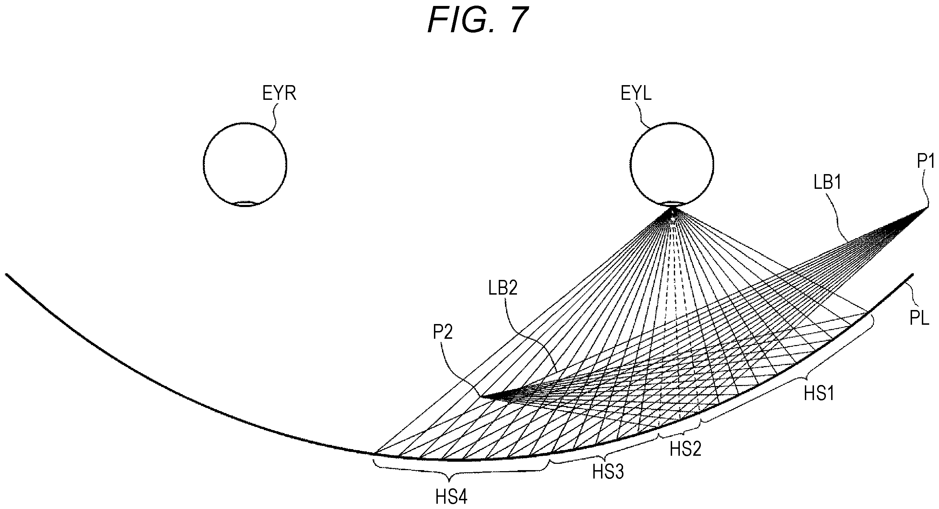

Fig. 7 is a geometric diagram illustrating the positional relationship between the left eye EYL of the observer, the resin plate PL, an emission point P1 of the first optical device, and an emission point P2 of the second optical device. Note that the hologram sheets described below are formed such that the emission direction of diffracted light gradually changes in accordance with the curvature of the resin plate PL. In any case, a single-exposure hologram emits diffracted light in one direction, and a multiple-exposure hologram emits diffracted light in two directions.

In order to form one image across the hologram sheets HS1 to HS4, the laser light LB1 is radiated from the emission point P1 to the hologram sheets HS2 to HS4, and the laser light LB2 is radiated from the emission point P2 to the hologram sheets HS1 to HS3. That is, in the first optical device 10, images corresponding to the hologram sheets HS2 to HS4 are formed separately, and the laser light LB1 corresponding thereto is emitted. In the second optical device 20, images corresponding to the hologram sheets HS1 to HS3 are formed separately, and the laser light LB2 corresponding thereto is emitted. Here, redundancy can be provided by providing the hologram sheet HS2 where laser light beams from both optical devices enter, which can make it easy to adjust the positions of the optical devices 10 and 20. Note that the emission points P1 and P2 are shifted in the direction perpendicular to the paper plane (X direction in Figs. 2 and 3) in relation to the eye EYL. Therefore, the optical devices do not block laser light.

Since only the laser light LB2 emitted from the emission point P2 enters the hologram sheet HS1 in a predetermined direction, a single-exposure hologram can be used as the hologram sheet HS1. Similarly, since only the laser light LB1 emitted from the emission point P1 enters the hologram sheet HS3 in a predetermined direction, a single-exposure hologram can be used as the hologram sheet HS3. Diffracted light emitted from single-exposure holograms enters the left eye EYL of the observer as illustrated by the solid lines in Fig. 7 to form a part of the image on the retina.

On the other hand, the laser light LB1 emitted from the emission point P1 in a first incident direction and the laser light LB2 emitted from the emission point P2 in a second incident direction simultaneously enter the hologram sheet HS2. Therefore, a multiple-exposure hologram is used as the hologram sheet HS2. Due to the characteristics of a multiple-exposure hologram, diffracted light generated from each of the laser light LB1 and the laser light LB2 that have entered in different directions enters the left eye EYL of the observer as illustrated by the dotted lines in Fig. 7 to form the rest of the image on the retina. This allows the observer to observe the entire image. Note that the description of the hologram sheet HS4 is omitted in this example.

Here, assuming that the intensity of the laser light LB1 and the intensity of the laser light LB2 are uniform, the intensity of diffracted light emitted from the hologram sheets HS1 and HS3 and the intensity of diffracted light emitted from the hologram sheet HS2 may be different from each other due to the difference in efficiency between a single-exposure hologram and a multiple-exposure hologram. For example, suppose that the diffraction efficiency of a single-exposure hologram and the diffraction efficiency of a multiple-exposure hologram are 100% and 80%, respectively, when laser light beams of the same intensity are radiated. Here, if parameters related to intensity other than diffraction efficiency are ignored, since the laser light LB 1 and the laser light LB2 simultaneously enter the hologram sheet HS2, the generated diffracted light is 80% × 2 = 160% when calculated simply, and the intensity thereof is higher than the intensity of diffracted light generated from the hologram sheets HS1 and HS3. Therefore, the control section CONT limits the amount of light that enters the hologram sheet HS2 out of the laser light LB1 emitted from the emission point P1 to 62.5%, and limits the amount of light that enters the hologram sheet HS2 out of the laser light LB2 emitted from the emission point P2 to 62.5%. Consequently, the intensity balance is secured in the hologram sheets HS1 to HS3, so that it is possible to emit diffracted light that causes less discomfort for the observer who observes the image. Note that the ratio of the amount of reduction of the laser light LB1 and the ratio of the amount of reduction of the laser light LB2 can be freely determined. The amount of reduction of one laser light may be made larger, and the amount of reduction of the other laser light may be made smaller.

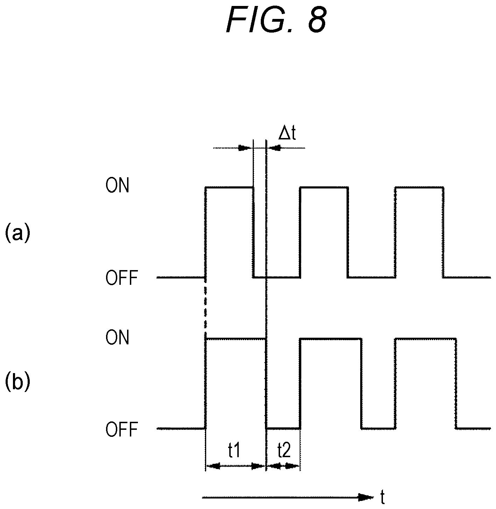

Fig. 8 is a diagram illustrating time-division control of the semiconductor laser performed by the control section CONT. For example, suppose the semiconductor laser 11 of the first optical device 10 is periodically turned on and off to control the amount of light (that is, the lighting time ratio is changed to control the amount of light at each pixel). When the laser light LB1 is emitted to the hologram sheet HS3, light emission time t1 and extinction time t2 are set as illustrated in Fig. 8(b). At the timing of emitting the laser light LB1 to the hologram sheet HS2, as illustrated in Fig. 8(a), the light emission time and the extinction time are respectively changed to (t1 - Δt) and (t2 + Δt), whereby the amount of light that enters the hologram sheet HS2 can be reduced to 62.5%. Similarly, suppose the semiconductor laser 21 of the second optical device 10 is periodically turned on and off to control the amount of light. When the laser light LB1 is emitted to the hologram sheet HS1, light emission time t1 and extinction time t2 are set as illustrated in Fig. 8(b). At the timing of emitting the laser light LB1 to the hologram sheet HS2, as illustrated in Fig. 8(a), the light emission time and the extinction time are respectively changed to (t1 - Δt) and (t2 + Δt), whereby the amount of light that enters the hologram sheet HS2 can be reduced to 62.5%.

Alternatively, the intensity of laser light that enters the holograms HS1 and HS3 may be increased to ensure the light amount balance of diffracted light generated from the hologram sheets HS1 to HS3. Note that the above control operation also applies to the third optical device 30 (emission point P3) and the fourth optical device 40 (emission point P4) having a mirror image relation with the first optical device 10 and the second optical device 20 with the center of the resin plate PL in between.

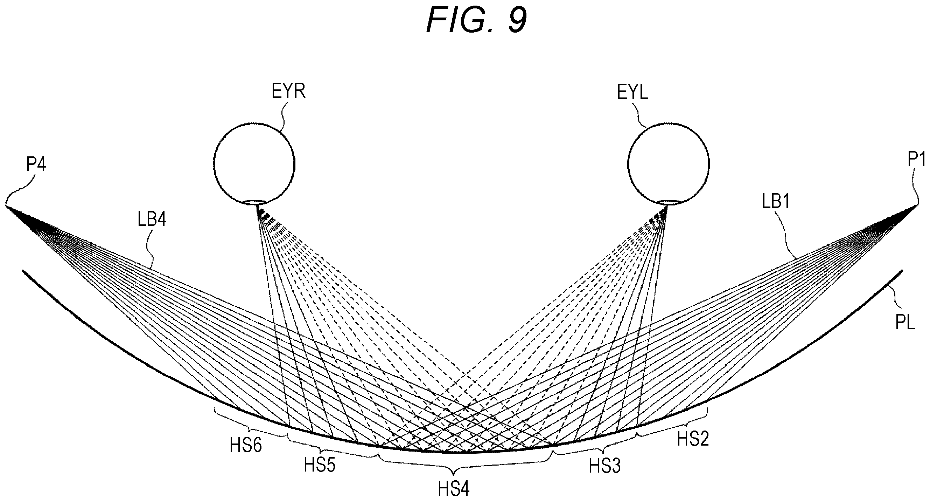

Fig. 9 is a geometric diagram illustrating the positional relationship between the observer's eyes EYL and EYR, the resin plate PL, the emission point P1 of the first optical device, and the emission point P4 of the fourth optical device. In order to form one image across the hologram sheets HS2 to HS6, the laser light LB1 is radiated from the emission point P1 to the hologram sheets HS2 to HS4, and laser light LB4 is radiated from the emission point P4 to the hologram sheets HS4 to HS6. That is, in the first optical device 10, images corresponding to the hologram sheets HS2 to HS4 are formed separately, and the laser light LB1 corresponding thereto is emitted. In the fourth optical device 40, images corresponding to the hologram sheets HS4 to HS6 are formed separately, and the laser light LB4 corresponding thereto is emitted. Here, redundancy can be provided by providing the hologram sheet HS4 where laser light beams from both optical devices enter, which can make it easy to adjust the positions of the optical devices 10 and 40.

Since only the laser light LB4 emitted from the emission point P4 enters the hologram sheet HS5 in a predetermined direction, a single-exposure hologram can be used as the hologram sheet HS5. Similarly, since only the laser light LB1 emitted from the emission point P1 enters the hologram sheet HS3 in a predetermined direction, a single-exposure hologram can be used as the hologram sheet HS3. Diffracted light emitted from the hologram sheet HS5 enters the right eye EYR of the observer as illustrated by the solid lines in Fig. 9 to form a part of the image on the retina. Diffracted light emitted from the hologram sheet HS3 enters the left eye EYL of the observer as illustrated by the solid lines in Fig. 9 to form a part of the image on the retina.

On the other hand, the laser light LB1 emitted from the emission point P1 in the first incident direction and the laser light LB4 emitted from the emission point P4 in the second incident direction simultaneously enter the hologram sheet HS4. Therefore, a multiple-exposure hologram is used as the hologram sheet HS4. Diffracted light generated by the laser light LB1 that has entered the hologram sheet HS4 enters the left eye EYL of the observer as illustrated by the dotted lines in Fig. 9 to form a part of the image on the retina. Diffracted light generated by the laser light LB4 that has entered the hologram sheet HS4 enters the right eye EYR of the observer as illustrated by the dotted lines in Fig. 9 to form a part of the image on the retina. Since the hologram sheet HS2 (HS6) has already been described, the description thereof is omitted.

Here, assuming that the intensity of the laser light LB1 and the intensity of the laser light LB4 are uniform, the intensity of diffracted light emitted from the hologram sheets HS3 and HS5 and the intensity of diffracted light emitted from the hologram sheet HS4 may be different from each other due to the difference in efficiency between a single-exposure hologram and a multiple-exposure hologram. For example, suppose that the diffraction efficiency of a single-exposure hologram and the diffraction efficiency of a multiple-exposure hologram are 100% and 80%, respectively, when laser light beams of the same intensity are radiated. In this example, diffracted light generated from the hologram sheet HS4 by the laser light LB1 is directed to the left eye EYL, and diffracted light generated from the hologram sheet HS4 by the laser light LB4 is directed to the right eye EYR. The intensity of each diffracted light beam is lower than that of diffracted light generated from the hologram sheets HS3 and HS5. Here, ignoring parameters related to intensity other than diffraction efficiency, the control section CONT increases the amount of light that enters the hologram sheet HS4 out of the laser light LB1 emitted from the emission point P1 to 125%, and increases the amount of light that enters the hologram sheet HS4 out of the laser light LB4 emitted from the emission point P4 to 125%. Consequently, the intensity balance is secured in the hologram sheets HS3 to HS5, so that it is possible to emit diffracted light that causes less discomfort for the observer who observes the image.

Taking the time-division control of the semiconductor laser illustrated in Fig. 8 as an example, when the laser light LB1 is emitted to the hologram sheet HS3 in the first optical device 10, for example, light emission time (t1 - Δt) and extinction time (t2 + Δt) are set as illustrated in Fig. 8(a). At the timing of emitting the laser light LB1 to the hologram sheet HS4, as illustrated in Fig. 8(b), the light emission time and the extinction time are respectively changed to t1 and t2, whereby the amount of light that enters the hologram sheet HS4 can be increased to 125%. Similarly, in the fourth optical device 40, when the laser light LB4 is emitted to the hologram sheet HS5, light emission time t1 and extinction time t2 are set as illustrated in Fig. 8(b), and light emission time (t1 - Δt) and extinction time (t2 + Δt) are set as illustrated in Fig. 8(a). At the timing of emitting the laser light LB1 to the hologram sheet HS4, as illustrated in Fig. 8(b), the light emission time and the extinction time are respectively changed to t1 and t2, whereby the amount of light that enters the hologram sheet HS4 can be increased to 125%.

Alternatively, the intensity of laser light that enters the holograms HS3 and HS5 may be reduced to ensure the light amount balance of diffracted light generated from the hologram sheets HS3 to HS5.

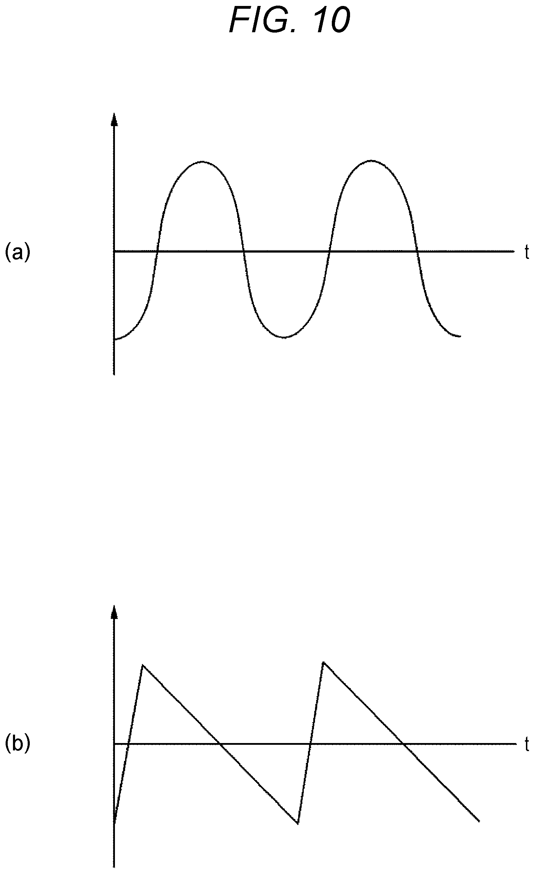

The scanning mirror 14 (Fig. 5) used in the present embodiment is of a type capable of two-dimensional scanning, and the inclination angles of the reflecting section 14e differ between inclination around the α-axis and inclination the β-axis. The fast rotation side is oscillated in a sinusoidal manner (see Fig. 10(a)), and the slow rotation side is oscillated in a sawtooth manner (see Fig. 10(b)). However, because of the characteristics of the scanning mirror 14, even the fast rotation side does not rotate at a constant angular velocity but rotates slowly on the periphery thereof. Therefore, if laser light is continuously emitted at a constant intensity and observed, the image formed by laser light reflected by the periphery appears bright to the observer. For this reason, it is necessary to reduce the amount of laser light in proportion to the rotation speed in the slow rotation range.

Since scanned laser light is obliquely applied to a hologram sheet and is folded back to the observer's eye, the density of scanning lines varies depending on the place when the observer observes. One problem with this is that distortion of an image occurs, but this can be dealt with by processing image data in advance so that distortion can be canceled. Another problem is that a portion with a coarse scanning line density appears dark. Parameters relating to brightness include the distance from the deflection point to the point of incidence on the hologram sheet at each deflection angle, the distance from the point of incidence on the hologram sheet to the eye, the angle between the incident light to the hologram sheet and the surface normal at the position of incidence, and the angle between the diffracted light from the hologram sheet and the surface normal. More specifically, the brightness seen by the observer varies in inverse proportion to the square of the distance from the deflection point to the hologram sheet, in proportion to the square of the distance from the hologram sheet to the eye, in proportion to the cosine of the angle between the incident light and the surface normal, and in inverse proportion to the cosine of the angle between the diffracted light and the surface normal. Therefore, the amount of laser light is desirably changed with each reciprocal number.

In order to display an image, it is necessary to perform on/off control on laser light, for example, in correspondence with image information to form the presence/absence of dots for each pixel. At this time, it is desirable to perform on/off control on laser light by multiplying the speed influence and the coarse/fine influence described above. This is done in addition to making the amount of laser light for a single-exposure hologram different from the amount of laser light for a multiple-exposure hologram.

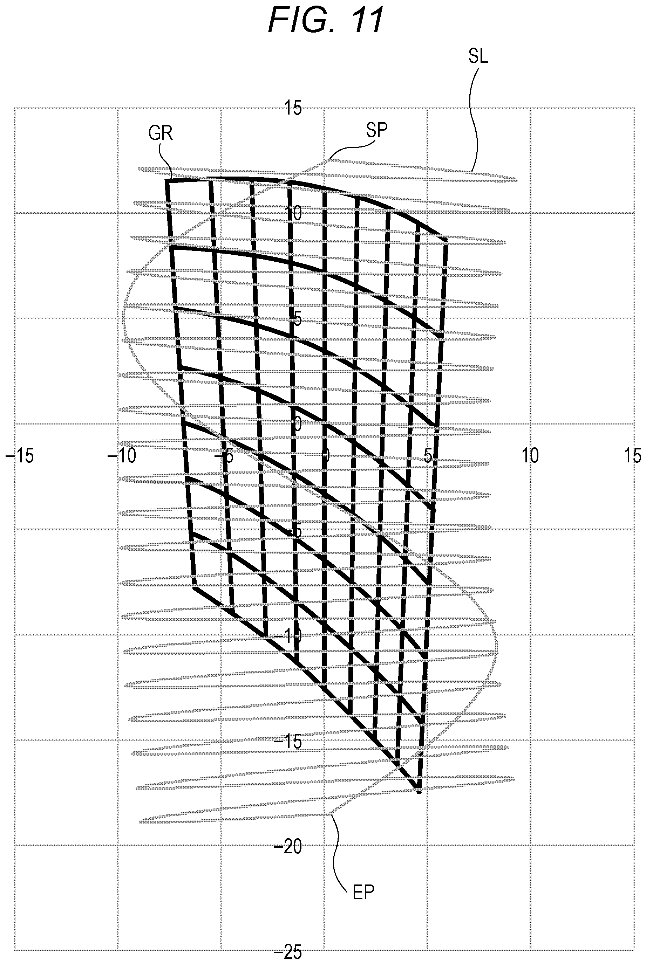

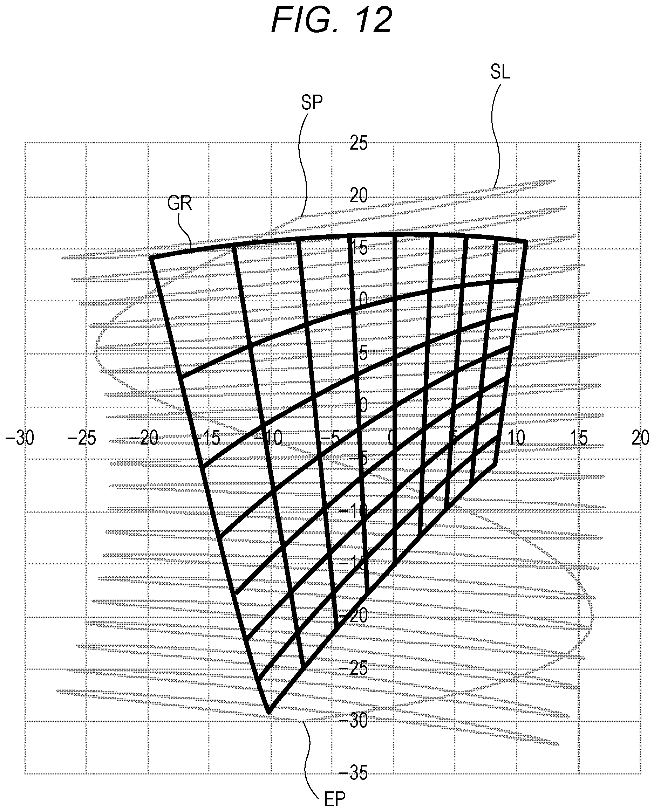

Fig. 11 is a diagram illustrating laser light emitted from the first optical device 10 as seen from the scanning mirror side, and Fig. 12 is a diagram illustrating laser light emitted from the second optical device 20 as seen from the scanning mirror side. The origin of the graph illustrated in each of Figs. 11 and 12 is the center of the range to be displayed by the scanning mirror. The vertical direction indicates a range of 18° on the upper side and a range of 24° on the lower side, and the horizontal direction indicates a range of ±24°. In each figure, scanning lines SL, which are the locus of the laser light, are scanned sinusoidally from a start point SP to an end point EP, and are returned to the start point SP again. For the sake of explanation, the scanning lines SL are drawn roughly, corresponding to 20 round trips (40 lines). In practice, however, about 1000 scanning lines SL are scanned with higher frequency.

The scanning mirror 14 (Fig. 5) oscillates with a constant amplitude on the sinusoidally oscillating side (see Fig. 9(a)). However, in order to spatially separate incident light and reflected light of the reflecting section 14e, the incident light is inclined. Then, even when the normal of the surface oscillates in the same angular range, the angular range of the reflected light changes according to the angle of the other axis, and the interval between the scanning lines also changes according to the angle of the other axis. As a result, as illustrated in Figs. 11 and 12, gentle, substantially fan-shaped regions are scanned. In the examples of Figs. 11 and 12, the incident light is inclined in a sinusoidally oscillating direction. Alternatively, the incident light may be inclined in the direction perpendicular to that direction. In this case, the distortion direction is rotated by 90 degrees.

On the other hand, the image to be formed by the scanning lines SL illustrated in Figs. 11 and 12 has a square grating shape including horizontal lines and vertical lines arranged at intervals of 6° when viewed by the eyes of the observer. In order to allow the observer to properly observe an image of such a grating shape, it is necessary to prepare in advance a distorted shape GR as image data as illustrated in Figs. 11 and 12. Such image data can be obtained by performing coordinate conversion of the intersection of the square grating shape with known software based on the positional relationship between the optical device and the hologram sheet.

The longer the distance from the scanning mirror to the point of incidence on the hologram sheet, the smaller the grating. When reaching the same eye, the overlap region is on the side close to the scanning mirror, where the grating is wide. In this example, the overlap region is a range of 12°, where the points on the gratings coincide when viewed from the eye side.

In the case of actually drawing an image, the control section CONT turns on laser light at the positions where the scanning lines SL and the gratings GR cross each other in Figs. 11 and 12, and turns off laser light at the other positions. As a result, dot-shaped light along the lines of the gratings enters the eyes of the observer, and a square grating can be observed using the afterimage.

In the present embodiment, control is performed to increase or decrease the amount of laser light in accordance with the above-described conditions with respect to the reference brightness. In practice, however, there is an upper limit to the amount of laser light, and control is performed as to whether the amount to be decreased is made larger or smaller with reference to the upper limit. In the above-mentioned control method for changing the accumulated amount of light on the eye side by changing the light emission time ratio by the time-division control, even in the brightest portion of the image, laser light is not continuously emitted, but a minute pause time is included. The pause time is further increased at the reference brightness position. The same control method should be used for forming an image using a liquid crystal or the like instead of laser light. In the portion of the image that needs to be the brightest portion, the brightness that the display element can express is set, and the image is displayed using a part of the dark side of the expressible range in the reference place.

The optical device that irradiates the hologram sheet with light may be a combination of a liquid crystal display and a lens, but it is advantageous in terms of miniaturization to scan light from the laser light source with a mirror or the like. In order to form an image with such a configuration, it is necessary to change light from the laser light source in accordance with an image signal. This can be achieved using a control method for changing the voltage applied to the laser light source to adjust the amount of emission light itself. However, making the laser light source emit light in a time-division manner to change the light emission time ratio is easier to control than making the laser light source continuously emit light. At that time, it is desirable to incorporate correction for the change in diffraction efficiency associated with the multiple exposure mentioned above by multiplying it by the change in accordance with an image signal. It is also desirable to reflect the variation of brightness due to the scanning speed change and the distribution of scanning line density viewed from the wearer. In the above-described embodiment, a monochrome image is formed using single-wavelength laser light sources. However, a color image can also be formed by using three-color laser light sources and preparing three-color holograms. Three-color holograms can be created, for example, by bonding together holograms corresponding to three colors or by simultaneous exposure of three colors.

The present invention is not limited to the embodiment described in the present specification. It is obvious for a person skilled in the art that the present invention also includes other embodiments and modifications based on the embodiment and technical ideas described in the present specification. The description and embodiment of the present specification are for illustrative purposes only, and the scope of the present invention is indicated by the following claims.

### Reference Signs List

- 10: first optical device
- 11: semiconductor laser
- 12: light guide path
- 13: lens
- 14: scanning mirror
- 14: scanning mirror
- 14a: fixed frame
- 14b: driving section
- 14c: movable frame
- 14d: torsion bar
- 14e: reflecting section
- 15: power supply section
- 20: second optical device
- 21: semiconductor laser
- 22: light guide path
- 23: lens
- 24: scanning mirror
- 30: third optical device
- 40: fourth optical device
- CONT: control section
- EL: electrode
- EP: end point
- EYL: left eye
- EYR: right eye
- FR: frame
- GR: grating
- HS1, HS3, HS5, HS7: single-exposure hologram sheet
- HS2, HS4, HS6: multiple-exposure hologram sheet
- LB1-LB4: laser light
- OH: head
- PL: resin plate
- PZ: piezoelectric element
- RL: reference light
- SL: scanning line
- SP: start point

## Claims

1. An image display device comprising:
a display section in which a single-exposure hologram and a multiple-exposure hologram are arranged side by side;
a plurality of optical units that emits light toward the single-exposure hologram and the multiple-exposure hologram; and
a control section that at least partially controls an amount of light emitted from the optical units, wherein
when light emitted from any of the optical units enters the single-exposure hologram along a predetermined incident direction, the light is diffracted in a direction toward an eye of an observer,
when light emitted from one of the optical units enters the multiple-exposure hologram along a first incident direction, the light is diffracted in a direction toward the eye of the observer, and when light emitted from another optical unit enters the multiple-exposure hologram along a second incident direction different from the first incident direction, the light is diffracted in a direction toward the eye of the observer, and
the control section controls the amount of light emitted from the optical units such that an intensity of diffracted light emitted from the single-exposure hologram to enter the eye of the observer and an intensity of diffracted light emitted from the multiple-exposure hologram to enter the eye of the observer approach one another, with a boundary interposed between the single-exposure hologram and the multiple-exposure hologram.

2. The image display device according to claim 1, wherein
when the diffracted light emitted from the multiple-exposure hologram is directed to the same eye of the observer, the control section performs control such that the amount of light emitted from the optical units toward the multiple-exposure hologram is smaller than the amount of light emitted from the optical units toward the single-exposure hologram, with the boundary interposed.

3. The image display device according to claim 1 or 2, wherein
when the diffracted light emitted from the multiple-exposure hologram is directed to different eyes of the observer, the control section performs control such that the amount of light emitted from the optical units toward the multiple-exposure hologram is larger than the amount of light emitted from the optical units toward the single-exposure hologram, with the boundary interposed.

4. The image display device according to any one of claims 1 to 3, wherein
the optical units each have a laser light source and a scanning system that scans a light flux emitted from the laser light source.

5. The image display device according to claim 4, wherein
the control section controls the amount of light emitted from the optical units by changing a lighting time ratio of the laser light source in a time-division manner in accordance with an image signal.

6. The image display device according to claim 5, wherein
the lighting time ratio is adjusted in accordance with a scanning speed of the light flux and a scanning line density viewed from the observer.

7. The image display device according to any one of claims 1 to 6, wherein
the image display device is installed on a head of the observer.
